# EUROPÄISCHE PATENTSCHRIFT

(11) **EP 2 196 435 B1**
(45) Veröffentlichungstag und Bekanntmachung des Hinweises auf die Patenterteilung: **08.06.2016**
(21) Anmeldenummer: 09177857.1
(22) Anmeldetag: 03.12.2009
(51) Int. Cl.: C30B 29/06, C30B 29/08, C22C 28/00, C01B 33/035

(54) **Verfahren zur Herstellung eines polykristallinen germaniumlegierten Siliciumstabes**
Method for the production of a polycrystalline germanium-alloyed silicon rod
Méthode de préparation d'un barreau d'alliage silicium-germanium polycristallin

(30) Priorität: 11.12.2008 DE 102008054519
(43) Veröffentlichungstag der Anmeldung: 16.06.2010
(73) Patentinhaber: Wacker Chemie AG, 81737 München (DE)
(72) Erfinder: Fabry, Laszlo, 84489, Burghausen (DE); Sofin, Mikhail, 84489, Burghausen (DE)
(74) Vertreter: Potten, Holger

(56) Entgegenhaltungen:
- EP-A2- 0 294 908
- EP-A2- 1 992 593
- WO-A2-2007/109403
- CH-A- 509 824
- J. WOLLWEBER, D. SCHULZ, W. SCHRÖDER: "SixGe1-x single crystals grown by the RF-heated float zone technique" JOURNAL OF CRYSTAL GROWTH, Bd. 163, 1. Juni 1996 (1996-06-01), Seiten 243-248, XP002600234

## Beschreibung

Die Erfindung betrifft ein Verfahren zur Herstellung eines polykristallinen germaniumlegierten Siliciumstabes.

Germaniumlegiertes Silicium weist in verschiedenen Anwendungen Vorteile gegenüber polykristallinem Silicium auf. So kann mit Germaniumlegierungen von Halbleitersilicium eine Bandlücke zwischen 1,7-1,1eV eingestellt werden. Dies ermöglicht die Steigerung des Wirkungsgrades von SiGe Stapelzellen z.B. in Solarmodulen, wenn die untere Zelle eine Bandlücke um etwa 1,2-1,4eV und die oberste eine Bandlücke bei etwa 1,7 eV besitzt. Insbesondere für Solar-Silicium besteht daher ein Bedarf an germaniumlegiertem Silicium. Aus dem Abstract zu JP5074783A2 (Fujitsu) ist ferner bekannt, dass Gettering von metallischen Verunreinigungen in germaniumlegierten Siliciumkristallen wirksamer ist als in reinen Si-Kristallen. Es wird angenommen, dass Germanium die Defektbildung vorteilhaft beeinflussen kann. Auch die Ladungsträgermobilität ist in gestreckten SSi-Strukturen höher als in reinem monokristallinem Silicium.

Bisher werden SSi-Schichten (SSi: Strained Silicon, gestrecktes Silicium) auf relaxierten SiGe Waferschichten mit zusätzlichem Aufwand durch Dotierung von Germaniumkristallen in Kristallziehanlagen (siehe z.B. EP1777753) oder durch Abscheidung von germaniumhaltigen Gasen auf reinem Silicium in einem Epi-Reaktor (siehe z.B. US20050012088) erzeugt.

Die Patentschrift CH 509 824 A beschreibt ein Verfahren zur Herstellung eines legierten Germanium-Silicium Halbleitermaterials, bei dem Eduktgase in einen Siemens-Reaktor geleitet werden und dort mit einem glühenden hochreinen Trägerkörper in Kontakt gebracht werden, wobei es auf dem Trägerkörper zu einer Abscheidung von polykristallinem germaniumlegierten Silicium kommt. Dieser Träger wird dann im erhitzten Zustand in ein vorbeiströmendes Gemisch aus Siliciumchloroform, Germaniumtetrachlorid und reinem Wasserstoff gehalten, so daß sich auf dem auf konstanter Glühtemperatur gehaltenen Träger die gewünschte polykristalline Silicium-Germanium-Legierung niederschlägt.

Aufgabe der vorliegenden Erfindung ist es ein einfaches und kostengünstiges Verfahren zur Herstellung eines hochreinen polykristallinen germaniumlegierten Siliciumstabes zur Verfügung zu stellen.

Die Aufgabe wird gelöst durch ein Verfahren gemäß Anspruch 1.

Unter hochrein ist im Sinne der vorliegenden Erfindung zu verstehen, dass der germaniumlegierte Siliciumstab maximal 1 ppma je Dotierstoff, 0,3ppma Kohlenstoff und maximal 0,1ppma andere Metalle mit Ausnahme von Germanium enthält.

Unter Dotierstoff sind dabei vorzugsweise flache Donatoren wie P, As, Sb und/oder flache Akzeptoren wie B, Al, Ga, In zu verstehen.

Vorzugsweise liegt im Stab die flache Donatordichte (die Menge an P, As, Sb) unter 3ppma, bevorzugt unter 1 ppba, besonders bevorzugt unter 0,3ppba und die flache Akzeptordichte (die Menge an B, Al, Ga, In) unter 3ppma, bevorzugt unter 1ppma, bevorzugt unter 0,3ppma, besonders bevorzugt 0,1ppba. Ein derartiges Material ist für Photovoltaik-Solar Anwendungen besonders geeignet.

Die meisten Solarzellen werden aus bordotiertem p-Typ Silicium hergestellt. Wenn der erfindungsgemäß hergestellte polykristalline Stab dafür überkompensiert werden muss, liegt die Donatordichte vorzugsweise unter 1ppma, bevorzugt unter 0,3ppma, um die spezifizierte netto Akzeptordichte von 100-300 ppba mit geringer Bordotierung einstellen zu können.

Vorzugsweise beträgt die Verunreinigung an Metallen mit Ausnahme von Germanium nicht mehr als 1ppba.

Unter einer polykristallinen Struktur ist im Sinne der vorliegenden Erfindung zu verstehen, dass der Stab aus Einzelkristallen besteht, die durch Korngrenzen voneinander getrennt werden, wobei die Einzelkristalle eine mittlere Korngröße zwischen 0,1 und 100 Mikrometer besitzen.

Der erfindungsgemäß hergestellte germaniumlegierte Siliciumstab kann zum FZ (Float-Zone)-Kristallziehen oder zum Nachchargieren im Czochralski-Verfahren verwendet werden. Derartige Verfahren werden analog zu der Herstellung von Einkristallen aus Silicium, wie sie beispielsweise in Semiconductor Silicon Crystal Technology von F. Shimura (Academic Press, London 1988, Seiten 124-127, 130-131, 135 und 179) beschrieben sind, durchgeführt.

Der erfindungsgemäß hergestellte germaniumlegierte Siliciumstab kann durch bekannte Verfahren in Bruchstücke zerkleinert werden. Derartige Verfahren sind beispielsweise in US2006/0088970A1 oder US2007/0235574A1 beschrieben. Diese Bruchstücke können ohne die bisher notwendige zusätzliche Germaniumdotierung als Ausgangsmaterial zur Herstellung von relaxierten SSi und/oder für blockgegossene multikristalline Produkte verwendet werden.

Das erfindungsgemäße Verfahren ermöglicht es, polykristallines germaniumlegiertes Silicium in herkömmlichen Siemens-Reaktoren, wie sie für die Produktion von polykristallinem Reinstsilicium eingesetzt werden, herzustellen. Die Dünnstäbe bestehen aus Silicium oder germaniumlegiertem Silicium.

Durch Variation des Verhältnisses Monogerman zu Monosilan im Eduktgas und der Temperatur des Dünnstabes bzw. des Substrats, auf dem die Abscheidung erfolgt, kann die Zusammensetzung und die Morphologie des abgeschiedenen Materials eingestellt werden.

Bei der Abscheidung des polykristallinen germaniumlegierten Siliciumstabs im Siemensreaktor unter Einsatz eines Monogerman/Monosilan-Gemisches im Eduktgas, wird aus diesem Gasgemisch bevorzugt Monogerman umgesetzt. Dies Verfahren ist aus wirtschaftlichen Gründen weniger zur Herstellung eines polykristallinen germaniumlegierten Siliciumstabes mit hohem Germaniumgehalt geeignet, sie bietet allerdings Vorteile, wenn ein polykristalliner germaniumlegierter Siliciumstab mit niedrigem Germanium-Gehalt, worunter vorzugsweise ein Germanium-Gehalt < 20mol.% zu verstehen ist, hergestellt werden soll. Bei einem Germaniumgehalt von weniger als 20mol.% im Monogerman/Monosilan-Gemisch wird Monogerman vollständig umgesetzt und das aus dem Reaktor ausströmende Abgas ist dementsprechend germaniumfrei. Dies vereinfacht die Behandlung des Abgases und ermöglicht dessen weitere Verwendung ohne zusätzliches Trennungsverfahren im Verbundsystem, welches bei kommerzieller Herstellung von Reinstsilicium fast immer eingesetzt wird (s. z.B. US4826668). Vorzugsweise wird in dieser Verfahrensvariante daher eine Mischung aus Monogerman zu Monosilan in einem molaren Verhältnis von 0,1:99,9 bis 50:50 eingesetzt.

Die Abscheidebedingungen entsprechen bei dieser Verfahrensvariante vorzugsweise denen, die bei der Herstellung vom Reinstsilicium aus SiH4 verwendet werden: Die Substrattemperatur liegt zwischen 400°C und 1000°C und die Eduktgassättigung liegt vorzugsweise zwischen 0,1mol.% und 10mol.%. Es ist vorteilhaft, die Zugabemengen an Eduktgas so auszuwählen, dass die SiGe-Ablagerungsgeschwindigkeit 0,1 bis 1,5mm pro Stunde beträgt. Diese Ablagerungsgeschwindigkeit stellt sich bei der angegebenen Temperatur und Sättigung ein, wenn der Durchsatz an GeH₄ und SiH₄ in der Summe zwischen 10 und 150Mol pro m² Substratfläche beträgt.

Die folgenden Beispiele dienen der weiteren Erläuterung der Erfindung. Alle Beispiele wurden in einem Siemensreaktor mit 8 Dünnstäben durchgeführt. Die zur Abscheidung verwendeten Dünnstäbe bestanden aus Reinstsilicium, waren 1m lang und hatten einen quadratischen Querschnitt von 5x5 mm. Da der Anteil des Dünnstabes im dicken abgeschiedenen Stab sehr klein ist (<0,5%) ist dessen Einfluss auf die gesamte Zusammensetzung des Stabes nach der Abscheidung vernachlässigbar klein. In allen Beispielen wurde der Gasdurchfluss so gesteuert, dass die Ablagerungsgeschwindigkeit im optimalen Bereich 0,1 bis 1,5mm/h lag. Bei Verwendung von Reaktoren mit der anderen Anzahl oder Länge der Dünnstäbe ist es notwendig, den Gasdurchfluss entsprechend anzupassen, wenn die gleiche Ablagerungsgeschwindigkeit gewünscht ist. Dasselbe gilt, wenn andere Substrate (z.B. Rohre oder Polygone) oder Temperaturen verwendet werden. In den folgenden Beispielen wurde die Gaszugabemenge in Abhängigkeit von der Wachstumsgeschwindigkeit geregelt. Die Wachstumsgeschwindigkeit wurde mittels des Stabdurchmesserzuwachses kontrolliert. Alternativ kann die Abscheiderate anhand der Zusammensetzung des aus dem Reaktor ausströmenden Abgases berechnet werden.

### Beispiel 1

Als Ausgangsverbindungen wurden GeH₄ und SiH₄ verwendet. Zusammen mit Wasserstoff (molare Anteile: GeH₄ 0,5%, SiH₄ 4,5%, Rest H₂) wurden diese Ausgangsverbindungen in den Siemensreaktor eingedüst. Die Abscheidung wurde mit konstanter Wachstumsgeschwindigkeit durchgeführt und dauerte 200 Stunden bei einer Stabtemperatur von 700°C. Die Stäbe erreichten dabei einen Durchmesser von ca. 135mm und wiesen einen Ge-Gehalt von 18mol.% auf.

## Patentansprüche

1. Verfahren zur Herstellung eines Stabes einer Länge von 0,5m bis 4m und mit einem Durchmesser von 25mm bis 220mm, umfassend einen Dünnstab aus Silicium oder germaniumlegierten Silicium, auf dem eine hochreine polykristalline Legierung aus Germanium und Silicium abgeschieden wird, indem ein Eduktgas bestehend aus Wasserstoff und einem Gemisch aus Monosilan und Monogerman und mit einem Germaniumanteil von weniger als 20 mol% in einen Siemens-Reaktor geleitet und dort mit dem Dünnstab, der eine Temperatur zwischen 400°C und 1000°C aufweist, in Kontakt gebracht wird, wobei es auf dem Dünnstab zu einer Abscheidung aus dem Eduktgas kommt, wobei die abgeschiedene Legierung aus 0,1 bis kleiner 20 mol.% Germanium und 99,9 bis 80 mol.% Silicium besteht.

2. Verfahren gemäß Anspruch 1, **dadurch gekennzeichnet, dass** das Eduktgas dem Siemens-Reaktor mit einer Eduktgassättigung von 0,1mol% bis 10mol% zugeführt wird, wobei der Durchsatz an Monogerman und Monosilan zwischen 10 und 150 Mol pro m² Substratoberfläche beträgt, so dass die Silicium/Germanium Legierung mit einer Geschwindigkeit von 0,1 bis 1,5mm pro Stunde auf dem Stab abgeschieden wird.

## Claims

1. Method for producing a rod having a length of 0.5 to 4 m and having a diameter of 25 mm to 220 mm, comprising a thin rod composed of silicon or germanium-alloyed silicon, on which a high-purity polycrystalline alloy composed of germanium and silicon is deposited by a procedure in which a starting gas comprising hydrogen and a mixture of monosilane and monogermane and having a germanium fraction of less than 20 mol% is introduced into a Siemens reactor and brought into contact there with the thin rod, which is at a temperature of between 400°C and 1000°C, wherein a deposition from the starting gas occurs on the thin rod, wherein the deposited alloy comprises 0.1 to less than 20 mol% germanium and 99.9 to 80 mol% silicon.

2. Method according to Claim 1, **characterized in that** the starting gas is fed to the Siemens reactor with a starting gas saturation of 0.1 mol% to 10 mol%, wherein the throughput of monogermane and monosilane is between 10 and 150 mol per m² substrate surface area, such that the silicon/germanium alloy is deposited on the rod at a rate of 0.1 to 1.5 mm per hour.

## Revendications

1. Procédé de fabrication d'une barre d'une longueur de 0, 5 m à 4 m et comprenant un diamètre de 25 mm à 220 mm, comprenant une barre mince en silicium ou en silicium allié de germanium, sur laquelle est déposé un alliage polycristallin extrêmement pur constitué de germanium et de silicium, en introduisant un gaz de départ constitué d'hydrogène et d'un mélange de mono-silane et de mono-germane et avec une teneur en germanium inférieure à 20 % en mole dans un réacteur Siemens et en le mettant en contact avec la barre mince qui présente une température comprise entre 400 °C et 1000 °C, un dépôt se produisant sur la barre mince à partir du gaz de départ, l'alliage déposé se composant de 0,1 à moins de 20 % en mole de germanium et de 99,9 à 80 % en mole de silicium.

2. Procédé selon la revendication 1, **caractérisé en ce que** le gaz de départ est acheminé au réacteur Siemens avec une saturation de gaz de départ de 0,1 % en mole à 10 % en mole, le rendement en mono-germane et en mono-silane étant compris entre 10 et 150 moles par m² de surface de substrat, de sorte que l'alliage de silicium/germanium soit déposé avec une vitesse de 0,1 à 1,5 mm par heure sur la barre.
